Europäisches Patentamt

European Patent Office

Office européen des brevets

Publication number: **0 298 737**

**A1**

## EUROPEAN PATENT APPLICATION

Application number: 88306206.9

Date of filing: 07.07.88

Int. Cl.⁴ **H01F 7/18 , H01H 47/32**

Priority: **10.07.87 JP 105955/87 U**

Date of publication of application:
**11.01.89 Bulletin 89/02**

Designated Contracting States:
**DE FR GB**

Applicant: **DIESEL KIKI CO., LTD.**
**No. 6-7, Shibuya 3-chome**
**Shibuya-ku Tokyo(JP)**

Inventor: **Kono, Hiromi c/o Diesel Kiki Co. Ltd.**
**Higashimatsuyama Plant 13-26 Yakyu-cho**
**3-chome**
**Higashimatsuyama-shi Saitama(JP)**

Representative: **Rackham, Stephen Neil et al**
**GILL JENNINGS & EVERY 53-64 Chancery**
**Lane**
**London WC2A 1HN(GB)**

### Solenoid drive circuit.

A solenoid drive circuit, provides both a starting current and a lower holding current to a solenoid coil (10). The coil (10) is connected in series with a drive transistor (11) which is turned ON to provide the starting current and alternately ON and OFF to provide the holding current. A series connected diode (14) and Zener diode (15) are connected in parallel to the solenoid coil (10). A first switching transistor (16) is connected in parallel with the Zener diode (15) and switched ON during the holding period to by-pass the Zener diode (15). This enables the back e.m.f. generated in the solenoid coil (10) to be used to sustain the current through the solenoid coil (10) during the holding period. Turning OFF the first switching transistor (16) restores the effect of the Zener diode (15) to provide a good OFF response for the drive circuit at the end of the holding period.

Fig-3

## Solenoid Drive Circuit

The present invention relates to a solenoid drive circuit for driving a solenoid coil actuated device such as a solenoid valve or relay.

In a conventional solenoid drive circuit a solenoid coil has one end connected to a power source, and its other end grounded via a collector-emitter circuit of a drive transistor. A series cathode-to-cathode connected diode and Zener diode are connected in parallel with the solenoid coil and the base of the drive transistor is connected via resistor to an input terminal to which a drive signal is applied.

According to this invention such a drive circuit also includes a first switching transistor which is connected in parallel with the Zener diode and arranged to be turned ON by a control signal having a second level to by-pass the Zener diode during a holding period in which the drive transistor is switched ON and OFF to reduce the current consumption of the solenoid drive circuit and to be turned OFF by a first level of the control signal to restore the effect of the Zener diode at the end of the holding period.

The present invention provides a solenoid drive circuit which has a lower power consumption but still has a good OFF response.

A particular example of a solenoid drive circuit in accordance with this invention will now be described and contrasted with the prior art with reference to the accompanying drawings; in which:-

Figure 1 is a circuit diagram of a conventional solenoid drive circuit;

Figure 2 are graphs illustrating the operation of the conventional circuit;

Figure 3 is a circuit diagram of an example of solenoid drive circuit according to the present invention; and,

Figure 4 is a series of graphs illustrating the operation of the circuit in accordance with this invention.

In a conventional solenoid drive circuit for driving a solenoid valve a solenoid coil 1 has one end connected to a power source, and the other end grounded via a collector-emitter circuit of a drive transistor 2. A series circuit of a cathode-to-cathode connected diode 3 and Zener diode 4 is coupled in parallel with the solenoid 1. The base of the drive transistor 2 is connected via a resistor to an input terminal IN, and a drive signal for driving the solenoid valve is input to the input terminal IN.

In this conventional drive circuit the back e.m.f. generated in the coil 1 on turning OFF the drive transistor 2 causes a current to continue to flow through the solenoid coil 1, the diode 3 and the Zener diode 4. However as soon as the back e.m.f.

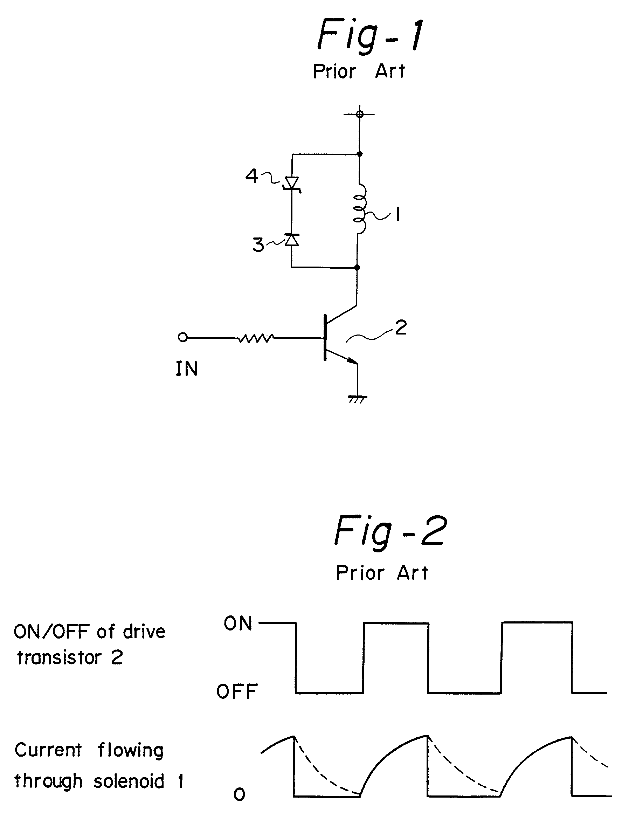

falls below the breakdown voltage of the Zener diode 4 this current is blocked which improves the OFF response of the drive circuit. As shown in Figure 2, the current which flows through the solenoid coil 1, when the drive transistor 2 is changed from ON to OFF, stops flowing more or less instantaneously as shown by a full line because the Zener diode 4 is present. On the other hand, if the Zener diode 4 is not present, current generated by the back e.m.f. flowing through the solenoid coil when the drive transistor 2 is changed from ON to OFF generates a current as shown by the broken line.

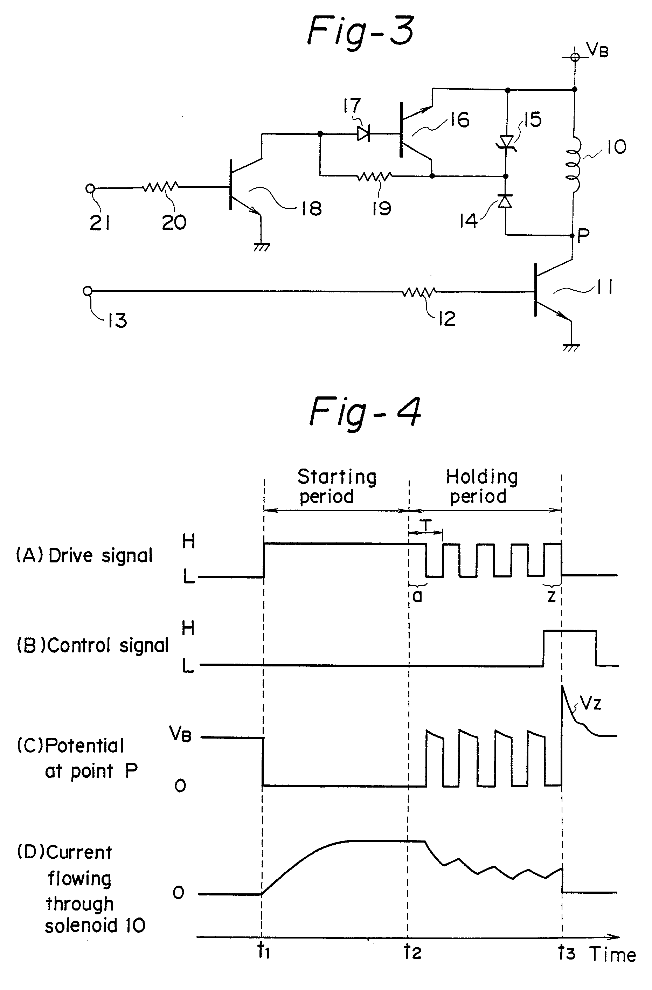

Now turning to a circuit in accordance with the present invention, a solenoid coil 10 has one end connected to a power source $V_B$, and its other end grounded via a collector-emitter circuit of a drive transistor 11. The base of the drive transistor 11 is connected via a resistor 12 to a drive signal input terminal 13. A drive signal is applied to the drive signal input terminal 13, and as shown by waveform (A) of Figure 4, this has a high level during a starting period $t_1$ - $t_2$ of the solenoid valve, and oscillates between the high level and a low level with cycle time T during a holding period $t_2$ - $t_3$. The drive signal is at the high level at the initial portion of the holding period, a high-level portion (a) as shown in Figure 4, and during the last portion, a high-level portion (z) as shown in Figure 4. The drive transistor 11, following the drive signal applied to the input terminal 13, is in an ON state during the starting period $t_1$ - $t_2$ of the solenoid valve and provides a starting current to the solenoid coil 10, and is switched ON and OFF periodically during the holding period $t_2$ - $t_3$ of the solenoid valve and gives a holding current, lower than the starting current, to the solenoid coil 10.

A series connected cathode-to-cathode circuit of a diode 14 and a Zener diode 15 is connected in parallel with the solenoid coil 10. A collector-emitter circuit of a first switching transistor 16 is connected in parallel with the Zener diode 15. A base of the first switching transistor 16 is grounded via a protection diode 17 and the collector-emitter circuit of a second switching transistor 18. The base of the first switching transistor 16 is also connected via the protection diode 17 and resistor 19 to a collector of the first switching transistor 16. A base of the second switching transistor 18 is connected via a resistor 20 to a control signal input terminal 21. A control signal applied to the control signal input terminal 21, as shown by a waveform (B) of Figure 4, inverts from a low level to a high level in synchronism with the last rising to the high level of the drive signal during the holding period, the rising edge of a high-level portion z of the waveform (A) of Figure 4, and returns to the low level after the lapse of a predetermined time after the end of the holding time $t_2 - t_3$. The second switching transistor 18 conducts when the control signal is high and is cut off when it is low. The first switching transistor 16, when the second switching transistor 18 is in an OFF state, conducts the back e.m.f. generated in the solenoid coil 10 and by-passes the Zener diode 15, and is cut off when the second switching transistor 18 is in an ON state.

In Figure 4, the waveform (A) shows the drive signal applied to the drive signal input terminal 13, the waveform (B) shows the control signal applied to the control signal input terminal 21, a waveform (C) shows a potential at a point P in the circuit of Figure 3, and a waveform (D) shows a current which flows through the solenoid 10.

When the drive signal becomes high at time $t_1$, the drive transistor 11 conducts, and the starting current flows through the solenoid 10. When the starting period has come to an end at time $t_2$ and the holding period starts, the drive signal starts repeating the high level and low level with cycle time T. A back e.m.f. is generated in the solenoid coil 10 and the first switching transistor 16 conducts and thereby the Zener diode 15 is by-passed. The drive transistor 11 conducts and is cut off in response to the repetition of the high level and low level of the drive signal, and thereby current flowing through the solenoid 10 is lowered. Since the Zener diode 15 is by-passed, current due to the back e.m.f. flows through the solenoid coil 10 when the drive transistor 11 is in OFF state, and, as shown in the waveform (D), the current generated by the back e.m.f. works as a holding current. When the drive signal rises at the last high-level portion (z) of the holding period, the control signal inverts from the low level to the high level synchronously with a rising edge of the last high-level portion (z). By the high level state of the control signal, the second switching transistor 18 is conductive. As a result, the first switching transistor 16 is turned OFF and the by-pass of the Zener diode 15 is interrupted. When the holding period comes to an end at time $t_3$, current flowing through the solenoid coil 10 due to generation of a back e.m.f. falls to zero almost immediately as shown by the waveform (C). Once the back e.m.f. voltage falls below the Zener voltage $V_z$ the current flow through the coil 10 is blocked by the existence of the Zener diode 15. Therefore, the OFF-response of the coil current at the end of the holding period is the same as in the conventional circuit. When the predetermined time passes after the end of the holding period, the control signal returns to the low level to be ready for the next operation.

The above-mentioned examples describes a solenoid valve but the present invention of course applicable to the drive circuit of a solenoid coil of a relay and other devices.

As described above in detail. the solenoid drive circuit according to the present invention provides a holding current by means of periodically switching the drive transistor ON and OFF and by-passing the Zener diode by means of the ON state of the first switching transistor. At the end of the holding period the first transistor is turned OFF and this interrupts the by-pass of the Zener diode. As a result of this, current due to the back e.m.f. is used as a holding current, and therefore the ON time of the drive transistor during the holding period can be shortened to reduce the power consumption of the circuit. Moreover, as the by-pass of the Zener diode is interrupted immediately before the end of the holding period, the OFF response of current flowing through the solenoid is not disturbed at the end of the holding time.

## Claims

1. A solenoid drive circuit comprising a drive transistor (11) connected in series with a solenoid coil (10) and arranged to be switched between an ON state and an OFF state in response to a drive signal having a first level to turn ON the drive transistor (11) and a second level to turn OFF the drive transistor (11), and a series connected diode (14) and a Zener diode (15) connected in parallel with the solenoid coil (10);

characterised by a first switching transistor (16) which is connected in parallel with the Zener diode (15) and arranged to be turned ON by a control signal having a second level to by-pass the Zener diode (15) during a holding period in which the drive transistor is switched ON and OFF to reduce the current consumption of the solenoid drive circuit and to be turned OFF by a first level of the control signal to restore the effect of the Zener diode at the end of the holding period.

2. A solenoid drive circuit according to claim 1. wherein the control signal, synchronous with the level changes of the drive signal. changes from the second level state to the first level state immediately before the end of the holding period.

3. A solenoid drive circuit according to claim 1 or 2, further including a second switching transistor (18) which receives the control signal and is switched ON when the control signal has the first level and switched OFF when the control signal has the second level, the first switching transistor (16) being OFF in response to the ON state of the second switching transistor (18), and being ON in response to the OFF state of the second switching transistor (18).

4. A solenoid drive circuit according to claim 3, wherein the base of the first switching transistor (16) is grounded via the collector-emitter circuit of the second switching transistor (18) and is also connected to the collector of the first switching transistor (16), and the second switching transistor (18) has its base connected to an input terminal (21) which receives the control signal.

5. A solenoid drive circuit comprising;

a drive transistor which is inserted in series with a solenoid and repeats an ON state and an OFF state in response to a drive signal which is a first level state during a starting period and repeats periodically the first level state and a second level state during a holding period, said drive transistor being conductive to give a starting current to said solenoid when said drive signal is in the first level state, and repeating the ON state and the OFF state to give a holding current, lower than said starting current, to said solenoid when said drive signal repeats the first level state and second level state periodically;

a serial circuit of a diode and a Zener diode which is inserted in parallel with said solenoid; and,

a first switching transistor which is inserted in parallel with said Zener diode and repeats an ON state and an OFF state in response to a control signal which is a first level state immediately prior to an end of said holding period and becomes a second level state by lapse of a predetermined time after an end of said holding period, said first switching transistor being the OFF state to interrupt a by-pass of said Zener diode when said control signal is the first level state, and being the ON state to by-pass said Zener diode when said control signal is the second level state.

6. A solenoid drive circuit according to claim 6, further including a second switching transistor which receiving said control signal is an ON state when said control signal is the first level state, and is an OFF state when said control signal is the second level,

said first switching transistor being the OFF state in response to the ON state of said second switching transistor, and being the ON state in response to the OFF state of said second switching transistor.

7. A solenoid drive cricuit according to claim 7, wherein said first switching transistor at its base is grounded via a collector-emitter circuit of said second switching transistor and is connected to a collector of said first switching transistor, and

said second switching transistor at its base is connected to an input terminal which receives said control signal,

said first switching transistor being the ON state by a counter electromotive force of said solenoid when said second switching transistor is the OFF state under the condition which is given the drive signal.

# Fig - 1
Prior Art

# Fig - 2
Prior Art

ON/OFF of drive
transistor 2

ON

OFF

Current flowing
through solenoid 1

O

EP 0 298 737 A1

## Fig-3

## Fig-4

(A) Drive signal

(B) Control signal

(C) Potential at point P

(D) Current flowing through solenoid 10

Starting period

Holding period

## DOCUMENTS CONSIDERED TO BE RELEVANT

| Category | Citation of document with indication, where appropriate, of relevant passages | Relevant to claim | CLASSIFICATION OF THE APPLICATION (Int. Cl. 4) |
|---|---|---|---|
| X | US-A-4 520 420 (NIPPONDENSO CO., LTD) * Column 3, line 50 - column 4, line 13; column 5, line 64 - column 6, line 56 * | 1 | H 01 F 7/18 <br> H 01 H 47/32 |
| A | US-A-4 316 056 (SIEMENS AG) | | |
| A | GB-A-2 095 065 (LUCAS INDUSTRIES LTD) | | |
| A | US-A-4 536 818 (FORD MOTOR CO.) | | |
| A | PATENT ABSTRACTS OF JAPAN, vol. 9, no. 39 (E-297)[1762], 19th February 1985; & JP-A-59 181 004 (FUJI DENKI SEIZO K.K.) 15-10-1984 | | |
| A | PATENT ABSTRACTS OF JAPAN, vol. 9, no. 43 (E-298)[1766], 22nd February 1985; & JP-A-59 184 504 (NISSAN JIDOSHA K.K.) 19-10-1984 | | |

TECHNICAL FIELDS SEARCHED (Int. Cl.4)

H 01 F 7/00
H 01 H 47/00
H 03 K 17/00

The present search report has been drawn up for all claims

| Place of search | Date of completion of the search | Examiner |
|---|---|---|
| THE HAGUE | 22-09-1988 | VANHULLE R. |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons

& : member of the same patent family, corresponding document

EPO FORM 1503 03.82 (P0401)